Europäisches Patentamt

European Patent Office

Office européen des brevets

(19)

(11) Publication number: **0 217 588**
**A1**

(12) # EUROPEAN PATENT APPLICATION

(21) Application number: **86307128.8**

(22) Date of filing: **16.09.86**

(51) Int. Cl.⁴: **H 05 K 3/34**

(30) Priority: **17.09.85 JP 203345/85**

(43) Date of publication of application:
**08.04.87 Bulletin 87/15**

(84) Designated Contracting States:
**BE DE FR GB IT NL**

(71) Applicant: **NIHON DEN-NETSU KEIKI CO., LTD.**
**27-1, Shimomaruko 2-chome, Ohta-ku**
**Tokyo (JP)**

(72) Inventor: **Kondo, Kenshi**
**3-5, Ohkura 1-chome Setagaya-ku**
**Tokyo (JP)**

(74) Representative: **Allam, Peter Clerk et al**
**LLOYD WISE, TREGEAR & CO. Norman House 105-109**
**Strand**
**London WC2R 0AE (GB)**

(54) Method and apparatus for fuse-bonding articles.

(57) A first article, such as a printed circuit board, to which a second article, such as an electric part, is previously and temporarily fixed with a fusible bonding agent, such as a solder paste or a solder preform, is heated by direct contact with a liquid heating medium, such as a fluorocarbon, having a boiling point higher than the melting point of the bonding agent, so that the bonding agent is fused. Cooling of the first therebetween.

FIG. 1

EP 0 217 588 A1

**Description**

## METHOD AND APPARATUS FOR FUSE-BONDING ARTICLES

This invention relates generally to bonding of articles. More particularly, the present invention is directed to a method and an apparatus for bonding two articles, maintained in a predetermined relative position. to each other with the use of a bonding agent such as a solder, provided between the two articles. by heating the two articles to fuse the bonding agent.

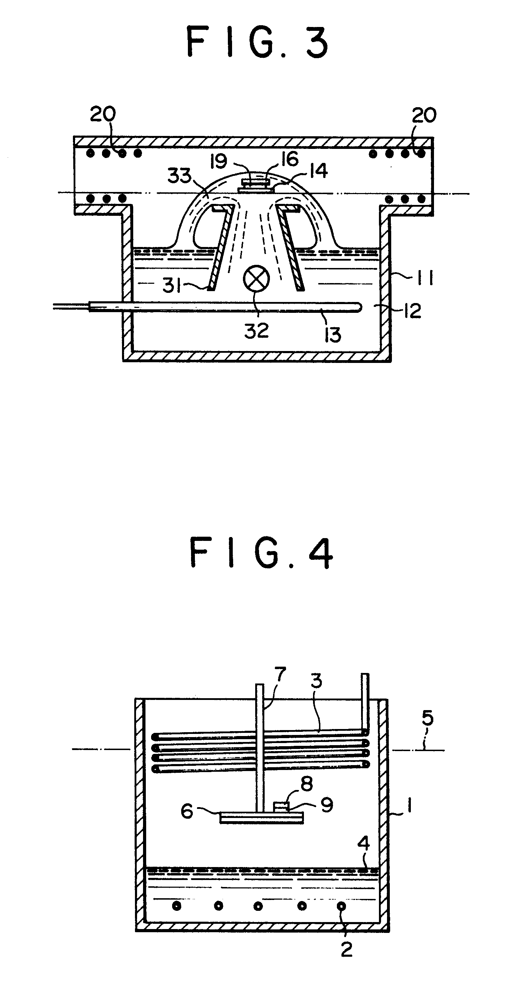

There is known a vapor phase soldering method in which the objects to be soldered are heated to a temperature appropriate for the soldering operation by condensing thereon hot vapors of a heat transfer liquid. Fig. 4 shows an apparatus for carrying out the vapor-phase soldering method as described in United States patent No. 3,866,307, in which indicated at 1 is a vessel, at 2 a heating coil, at 3 a cooling coil, and at 4 a heat transfer liquid such as a fluorinated polyoxypropyrene. The heat transfer liquid 4 is filled in the vessel 1 up to the level shown, and heated to and maintained at a temperature above its boiling point by the heating coil 2. Hot vapors of the heat transfer liquid 4 are filled up to the level of the cooling coil 5, which is indicated by the chain line 5, and condensed at that level and returned to the body of the heat transfer liquid in 4fe lower portion of the vessel 1. Denoted at 6 is a printed circuit board, at 7 a supporting member for mounting and holding the printed circuit board 6 thereon, at 8 a chip part such as an IC component to be bonded to the printed circuit board 6, and at 9 a bonding agent which is in this case soldering paste having powdery solder mixed with a paste and which is applied on the upper side of the printed circuit board 6 and on the lower side of the chip part 8 beforehand. The heat transfer liquid has a boiling point not lower than the melting point of the soldering paste.

With this arrangement, the heat transfer liquid 4 is boiled to generate vapors and to melt the soldering paste 9 by using the latent heat of the vapors. Then the holder member 7 is lifted up to cool and solidify the solder in the air with the aid of the cooling coil 3, thereby bonding the chip part 8 to the printed circuit board 6.

In the above vapor phase soldering method, it is difficult to prevent outflows of vapors through the opening of the vessel 1, inviting large economical loses due to the large consumption of the expensive heat transfer liquid 4. In addition, the operating temperature range is very narrow for the bonding operation which is feasible only at a predetermined temperature. Moreover, it takes relatively a long time to melt the soldering paste 9 by the vapors, failing to meet the demand for a high speed bonding operation.

The present invention contemplates to solve the above-mentioned problems. In accordance with one aspect of the present invention there is provided an improved method of bonding first and second articles to each other with a bonding agent, which comprises maintaining the first and second articles in a predetermined relative position with the bonding agent being provided between the surfaces of the first and second articles at which they are to be bonded, heating the first and second articles to fuse the bonding agent, and cooling the first and second articles to solidify the fused bonding agent, the improvement comprising said heating step which includes contacting the first and second articles with a liquid heating medium having a boiling point higher than the melting point of the bonding agent.

In another aspect, the present invention provides an apparatus for bonding first and second articles maintained in a predetermined relative position with a fusible bonding agent provided therebetween. comprising:

means for transferring said first and second articles along a predetermined path of travel, and

means for forming a body of a liquid heating medium adjacent to said path so that at least a portion of said first and second articles is brought into direct contact with said body during their passage through said path.

The present invention will now be described in detail below with reference to the accomapanying drawings, in which:

Figs. 1 through 3 are vertical, cross-sectional views diagrammatically showing preferred embodiments of the apparatuses suitable for carrying out the process according to the present invention; and

Fig. 4 is a vertical cross section similar to

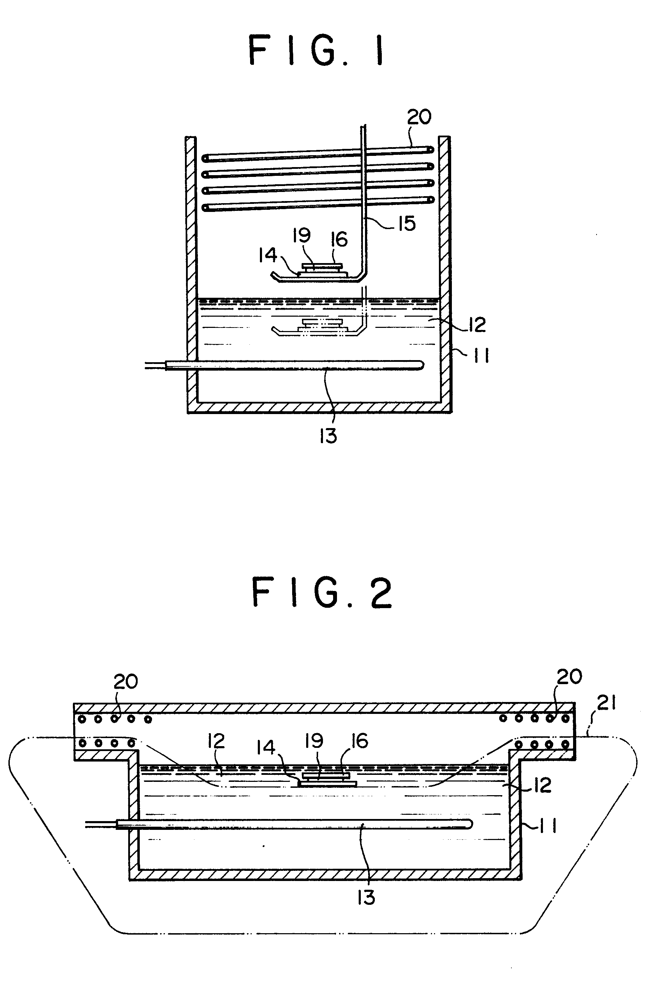

Figs. 1-3 showing conentional vapor-phase bonding apparatus.

Referring now to Fig. 1, there is illustrated an example of the apparatus according to the present invention, in which designated as 11 is a vessel for containing a liquid heating medium 12 which may be, for example, an inert fluorocarbon such as Florinate (a trademark of Sumitomo 3M, Inc.). Denoted at 13 is a heater for heating the liquid heating medium, at 14 a printed circuit board or a first article, at 15 a supporting member for mounting and holding the printed circuit board thereon, and at 16 an electric part or second article to be fuse-bonded to the printed circuit board 14. A bonding agent such as a solder paste 9 is provided between the printed circuit board 14 and the electric part 16. The heating medium 12 should have a boiling point higher than the melting point of the solder paste 9. The reference numeral 20 designates a cooler for preventing vapors of the heating medium 12 from escaping out of the vessel.

In operation, the solder paste 9 is pre-coated on predetermined bonding area of the printed circuit board 14 and electric part 16 for temporarily fixing the part 16 at position on the board 14. The heating medium 12 is heated by the heater 13 to a temperature equivalent to or slightly higher than the melting point of the solder paste 9 but is sufficiently lower than its boiling point. For example, a fluorocarbon having a boiling point of 215 °C is heated to about 185 °C for fusing a solder paste with a melting point of 183.3 °C. As the printed circuit board 14, electric part 16 and solder paste 9 are immersed in the heating medium to the level indicated by two-dotted chain line, the solder paste 9 is heated and melted upon receipt of the heat from the heating medium 12. The solder paste 9 is then cooled and solidified when the supporting member 15 is moved and the printed circuit board 14 leaves the heating medium 12. Vapors of the heating medium generated are condensed by the cooler 20.

Referring to Fig. 2, there is illustrated another embodiment of the present invention, in which the component parts common with those of Fig. 1 are designated by the same reference numerals and wherein indicated at 21 is a conveyor chain employed as a conveyor means for supporting printed circuit boards 14 thereon and for transferring same along a predetermined path. The conveyor chain 21 lowers the printed circuit board 14, to which an electric part is pre-fixed with a solder paste 9, to immerse same in a heating medium 12 contained in a vessel 11 and to melt the solder paste 9, and then moves upward to cool and solidify the solder paste.

Fig. 3 illustrates a further embodiment of the present invention, in which the component parts common with those in Fig. 2 are designated by the same reference numerals and wherein indicated at 31 is an upwardly extending nozzle member provided inside of a vessel, and at 32 a pump for forming overflowing standing wave 33 of the heating medium. A printed circuit board 14 bearing an electric part 16 temporarily fixed thereon by a solder paste or preform 9 is transferred by a conveyor chain 21 and passed through the wave 33 so that the solder paste 9 is fused. Upon leaving the heating medium wave 33, the solder paste 9 is solidified to firmly fix the electric part 16 to the printed circuit board 14. It is of course possible to use a moving wave of the heating medium, if desired.

In the foregoing embodiments, the articles which have taken off from the heating medium generally enrain droplets of the heating medium. The entrained droplets may be removed from the articles by puring with a gas such as air or by washing with a suitable liquid. The removed heating medium may be recovered for reuse.

In the present invention, it is not necessary to heat the heating medium above its boiling point. Because a greater amount of thermal energy is available in liquid state, the bonding agent can be melted within a short period of time. Consequently, the period of time over which the printed circuit board and chip parts are exposed to a high temperature can be shortened to prevent thermal damages thereof. In addition, since the heating medium is in the liquid state, it becomes possible to vary the operation temperature for melting the bonding agent depending upon the thermal properties of the printed circuit boards and electric parts. Since there is little possibility of the heating medium escaping from the vessel, the loss of the heating medium may be minimized.

The invention may be embodied in other specific forms without departing from the spirit or essential charcteristics thereof. The present embodiments are therefore to be considered in all respects as illustrative and not restrictive, the scope of the invention being indicated by the appended claims rather than by the foregoing description, and all the changes which come within the meaning and range of equivalency of the claims are therefore intended to be embraced therein.

## Claims

1. In a method of bonding first and second articles to each other with a bonding agent, which comprises maintaining the first and second articles in a predetermined relative position with the bonding agent being provided between the surfaces of the first and second articles at which they are to be bonded, heating the first and second articles to fuse the bonding agent, and cooling the first and second articles to solidify the fused bonding agent, the improvement comprising said heating step which includes contacting the first and second articles with a liquid heating medium having a boiling point higher than the melting point of the bonding agent.

2. The method according to claim 1, wherein said contact is by immersing or dipping at least a portion of the first and second articles in the liquid heating medium.

3. The method according to claim 2, wherein the liquid heating medium is stationarily contained in a vessel.

4. The method according to claim 2, wherein the liquid heating medium is in the form of a standing or moving wave.

5. The method according to claim 1, wherein the bonding agent is a solder.

6. The method according to claim 5, wherein the liquid heating medium is a fluorocarbon.

7. An apparatus for bonding first and second articles maintained in a predetermined relative position with a fusible bonding agent provided therebetween, comprising:

means for transferring said first and second articles along a predetermined path of travel, and

means for forming a body of a liquid heating medium adjacent to said path so that at least a portion of said first and second articles is brought into direct contact with said body during their passage through said path.

# FIG. 1

# FIG. 2

# FIG.3

20                    20

33    19   16   14

31          32   13   11   12

# FIG.4

7    3

5

8

6    9

4

1

2

## DOCUMENTS CONSIDERED TO BE RELEVANT

EP 86307128.8

| Category | Citation of document with indication, where appropriate, of relevant passages | Relevant to claim | CLASSIFICATION OF THE APPLICATION (Int. Cl.4) |
|---|---|---|---|
| A | US - A - 4 032 033 (CHU) <br> * Abstract; fig. 1; claims 1-7 * | 1,7 | H 05 K 3/34 |
| A | US - A - 3 904 102 (CHU) <br> * Abstract; fig. 1-3; claims 1-27 * | 1,7 | |
| D,A | US - A - 3 866 307 (PFAHL) <br> * Abstract; fig. 1-3; claims 1-16 * | 1,7 | |
| A | EP - A1 - 0 106 295 (HTC-CORP.) <br> * Abstract; fig. 1 * | 1,7 | |
| A | US - A - 3 765 475 (HOOPER) <br> * Abstract; fig. 1 * | 1,7 | **TECHNICAL FIELDS SEARCHED (Int. Cl.4)** <br><br> H 05 K 3/00 |
| A | US - A - 4 538 757 (BERTINGER) <br> * Totality * | 1 | B 23 K 1/00 <br> B 23 K 3/00 |
| A | GB - A - 2 105 208 (HTC-CORP.) <br> * Fig. 1 * | 1 | |

----

The present search report has been drawn up for all claims

| Place of search | Date of completion of the search | Examiner |
|---|---|---|
| VIENNA | 16-12-1986 | VAKIL |